Europäisches Patentamt

European Patent Office

Office européen des brevets

(19)

(11) Veröffentlichungsnummer: **0 551 573 A2**

# EUROPÄISCHE PATENTANMELDUNG

(12)

(21) Anmeldenummer: **92117586.5**

(22) Anmeldetag: **15.10.92**

(51) Int. Cl.5: **H04L 27/12**

(30) Priorität: **15.01.92 DE 4200816**

(43) Veröffentlichungstag der Anmeldung:
**21.07.93 Patentblatt 93/29**

(84) Benannte Vertragsstaaten:
**AT DE DK FR GB IT NL SE**

(71) Anmelder: **ROBERT BOSCH GMBH**
**Postfach 30 02 20**
**W-7000 Stuttgart 30(DE)**

(72) Erfinder: **Ketterling, Hans-Peter, Dipl.-Ing.**
**Boeckelstrasse 74**
**W-1000 Berlin 42(DE)**

(54) **Winkelmodulator, insbesondere für digitale Funkübertragung.**

(57) 2.1. Der Erfindung liegt die Aufgabe zugrunde, durch die Mitbenutzung von Schaltungsteilen, die für die Frquenzgenerierung ohnehin benötigt werden, einen einfachen und wirtschaftlichen digitalen Modulator anzugeben.

2.2. Die Aufgabe wird dadurch gelöst, daß der Ausgang z.B. eines spannungsgesteuerten Quarzoszillators (VCXO) mit dem Eingang eines Festteilers verbunden ist, daß der Ausgang des Festteilers mit dem Eingang eines einstellbaren Teilers, der gemeinsam mit einem Diskriminator und einem zweiten einstellbaren Teiler initialisierbar ist, verbunden ist, daß der erste einstellbare Teiler mit einem Eingang des Diskriminators verbunden ist, daß der andere Eingang des Diskriminators über den zweiten einstellbaren Teiler mit dem Ausgang eines spannungsgeregelten Oszillators (VCO) verbunden ist, daß der Ausgang des Diskriminators über ein Schleifenfilter mit einem Eingang eines Summierers (Σ) verbunden ist, daß der Ausgang des Summierers mit dem VCO verbunden ist und daß am Ausgang des VCO das Ausgangssignal abgreifbar ist.

2.3. Ein bevorzugtes Anwendungsgebiet ist der Einsatz im Landmobilfunk.

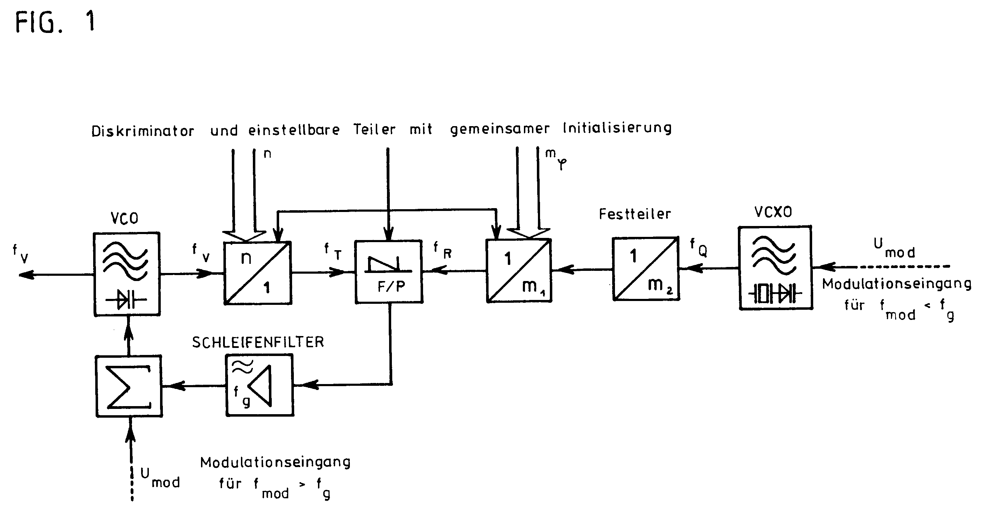

3. Die Zeichnung zeigt die PLL-Frequenzaufbereitung für ein Landmobilfunkgerät (Fig. 1).

FIG. 1

Diskriminator und einstellbare Teiler mit gemeinsamer Initialisierung

EP 0 551 573 A2

Die Erfindung betrifft einen Frequenz- und Phasenmodulator für digitale Modulation bzw. digitale Übertragung.

Sein Anwendungsgebiet ist insbesondere der Landmobilfunk.

Nachrichten, die zunächst im Basisband vorliegen, können aus den verschiedensten Gründen in dieser Form meistens nicht direkt übertragen werden. Als Träger der jeweiligen Nachricht wird deshalb vielfach ein RF-Signal benutzt, welches dann mit dieser Nachricht moduliert wird.

Von den bekannten Winkelmodulatoren sind solche besonders gut für den Einsatz im Landmobilfunk geeignet, die mit konstanter Amplitude bzw. Hüllkurve arbeiten. Damit können Senderleistungsverstärker im C-Betrieb verwendet werden, und in den Empfängern ist der Einsatz von Begrenzerverstärkern möglich, was besonders wirtschaftliche Lösungen begünstigt.

Für die Realisierung digitaler Frequenz- und Phasenmodulatoren sind verschiedene Möglichkeiten bekannt, von denen einige besonders einfach sind bzw. über besonders günstige Eigenschaften verfügen.

Für die Modulation und die Demodulation können teilweise die gleichen Mittel eingesetzt werden, Phasen- und Frequenzregelschleifen sind hierfür ein gutes Beispiel. Zu beachten ist, daß solche Modulatoren in vielen Fällen mit den Frequenzaufbereitungen zusammengefaßt werden können.

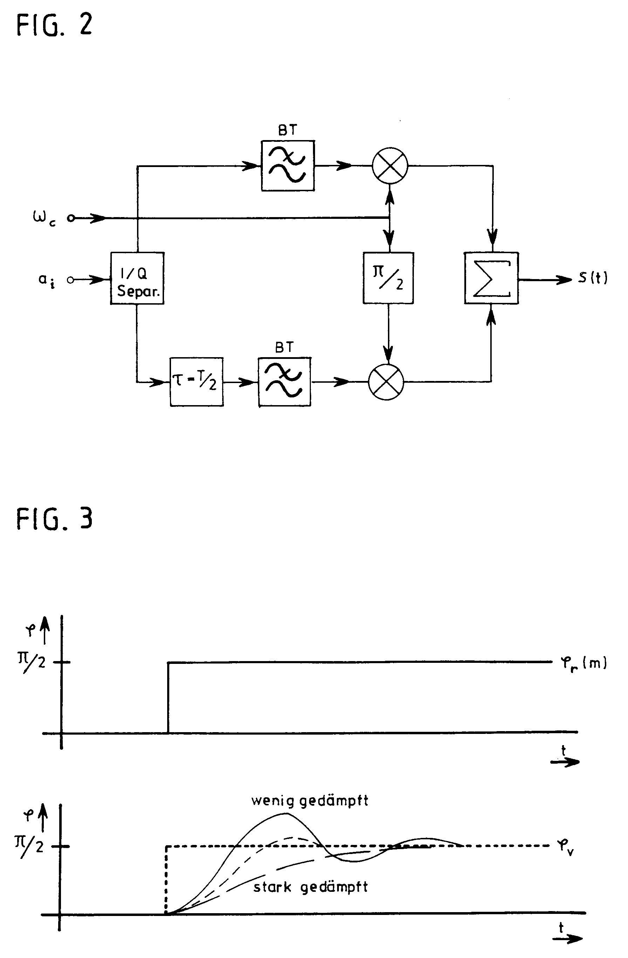

Der einfachste Fall eines digitalen Frequenz- und Phasenmodulators ist der des binären digitalen Phasenmodulators, der im Prinzip durch einen simplen Umpoler realisiert werden kann, dann jedoch ein sehr breitbandiges Schaltspektrum produziert. Will man kontrollierte, weiche Phasen-Übergänge erzielen, um die Modulationsbandbreite zu reduzieren, so muß das Basisbandsignal zunächst entsprechend geformt werden, entweder durch Filterung oder durch ein Tabellenverfahren und DA-Wandlung, wonach es mit der Trägerfrequenz multipliziert wird. Wenn das Basisband den Wertebereich zwischen -1 und +1 einnimmt, erhält man nach der Multiplikation direkt den modulierten Träger. Statt eines echten Multiplikators kann man z.B. auch Ringmischer einsetzen, wobei anschließend die Oberwellen ausgefiltert werden müssen. Im Falle von Vierphasenmodulation (QPSK) und Offset-QPSK (OQPSK) wird vielfach die bekannte Anordnung von Fig. 2 verwendet, bei der das resultierende Signal durch Addition zweier orthogonaler Einzelsignale gewonnen wird. Die Verhältnisse bei weichen Übergängen entsprechen dem vorher behandelten binären Fall. GMSK kann übrigens als Offset-QPSK mit definiertem BT-Produkt interpretiert werden, d.h. nach Basisbandfilterung mit geeignetem BT-Produkt kann ein QPSK-Modulator verwendet werden, wenn zusätzlich der erforderliche Offset zwischen den I- und Q-Komponenten des Modulationssignales erzeugt wird. Damit ergeben sich genau kontrollierte Phasenhübe, und der erforderliche Modulationsindex h = 0,5 kann sehr präzise eingehalten werden.

Für das Ausgangssignal derartiger Modulatoren kann man schreiben:

$$s(t) = \sqrt{\frac{2E_B}{T}} \cdot \cos[\omega_c t + \varphi(t)]$$

$$\varphi(t) = \sum_{1}^{1,n} a_1 \cdot \pi h \cdot \int_0^T g(t)\, dt$$

Hierbei ist s(t) die Zeitfunktion, $E_B$ die Energie pro Bit, T die Bitlänge, $\phi(t)$ die Momentanphase, h der Modulationsindex und a der Wert des i-ten Bit($\pm$1), während g(t) den Zeitverlauf der Phase beschreibt.

Der Erfindung liegt die Aufgabe zugrunde, durch geringen Aufwand und die Möglichkeit der Mitbenutzung von Schaltungsteilen, die für die Frequenzgenerierung ohnehin benötigt werden, einen einfachen und wirtschaftlichen digitalen Modulator anzugeben.

Erfindungsgemäß wird die Aufgabe dadurch gelöst, daß der Ausgang z.B. eines spannungsgesteuerten Quarzoszillators (VCXO) mit dem Eingang eines Festteilers verbunden ist, daß der Ausgang des Festteilers mit dem Eingang eines einstellbaren Teilers, der gemeinsam mit einem Diskriminator und einem zweiten einstellbaren Teiler initialisierbar ist, verbunden ist, daß der erste einstellbare Teiler mit einem Eingang des Diskriminators verbunden ist, daß der andere Eingang des Diskriminators über den zweiten einstellbaren Teiler mit dem Ausgang eines spannungsgeregelten Oszillators (VCO) verbunden ist, daß der Ausgang des Diskriminators über ein Schleifenfilter mit einem Eingang eines Summierers (Σ) verbunden ist, daß der Ausgang des Summierers mit dem VCO verbunden ist und daß am Ausgang des VCO das Ausgangssignal abgreifbar ist.

Die erfindungsgemäße, in Fig. 1 gezeigte, PLL-Frequenzaufbereitung für ein Landmobilfunkgerät ist infolge geringfügiger Erweiterungen für die Frequenzmodulation (FM) geeignet. Dies gilt sowohl für analoge als auch für digitale FM. Analoge Phasenmodulation (PM) kann damit ebenfalls realisiert werden, indem das NF- bzw. Basisbandsignal vor der Modulation differenziert wird, in der Praxis also über einen NF-Modulationsverstärker mit einem Frequenzgang von +6 dB/Okt geschickt wird. Erfindungsgemäß eignet sich diese PLL- Schaltung auch für digitale PM. Befindet sich die PLL in stationärem Zustand, so gilt:

$$f_R = \frac{f_Q}{m_1 \cdot m_2} = \frac{f_V}{n} \qquad (1)$$

$$\varphi_R = \frac{\varphi_Q}{m_1 \; m_2} = \frac{\varphi_V}{n} \qquad (2)$$

Die Referenzfrequenz solcher Schaltungen beträgt bei normalen Landmobilfunkgeräten 10 kHz (z.B. wegen des Halbrasterversatzes im 20-kHz-Raster) oder 12,5 bzw. 25 kHz, um die gängigen Kanalraster von 10, 12,5 und 25 kHz erzeugen zu können, und bei 200 kHz im GSM-System. Die Schleifengrenzfrequenz liegt größenordnungsmäßig bei 1 % der Referenzfrequenz oder weniger, da andernfalls keine ausreichende Unterdrückung der von der Referenzfrequenz herrührenden Seitenbänder der erzeugten Frequenz möglich ist. Damit ergeben sich Grenzfrequenzen von unter 100 Hz für normale Mobilfunkgeräte und weniger als 2 kHz für GSM-Mobiltelefone.

Für die Modulation ergibt sich als einfachste Möglichkeit die Addition der Signalspannung zur Schleifenregelspannung hinter dem Schleifenfilter. Damit werden alle Modulationsanteile oberhalb der Schleifengrenzfrequenz direkt wirksam, während unterhalb eine Gegenkopplung erfolgt, d.h. diese Methode erlaubt nicht die Einführung von Gleichgrößen oder von Modulationsfrequenzen unterhalb der Schleifengrenzfrequenz. Vorteilhaft ist jedoch, daß normale PLL-Synthesizer mit einfachen Mitteln derart erweitert werden können, daß sie für die Erzeugung analoger FM einsetzbar sind. Nachteilig ist bei diesem Verfahren, daß der Spitzenhub sauber eingestellt werden muß, aber prinzipiell nicht exakt definiert ist und nicht präzise konstant gehalten werden kann, weil er aufgrund der nichtlinearen VCO-Kennlinie von der jeweiligen VCO-Frequenz abhängig ist, vom Driften infolge von Temperatur- oder Alterungseinflüssen einmal ganz abgesehen.

Wenn eine PLL-Frequenzaufbereitung benutzt wird, deren Frequenz mit einer anderen gemischt wird, z.B. um den notwendigen Versatz zwischen Empfängerhilfsfrequenz und Sendefrequenz zu realisieren, oder weil man mit einer Einschleifenlösung nicht auskommt (z.B. bei Frequenzaufbereitungen für Duplexgeräte), liegt die Referenzfrequenz oft bei mehreren MHz. Dann ist jedoch eine Schleifengrenzfrequenz realisierbar, die oberhalb der Grenzfrequenz des Basisbandes liegt. In diesem Fall, der auch Mikrophonieeffekte und dergleichen besonders leicht zu beherrschen gestattet, kann die Modulation sehr elegant über die dementsprechend hoch liegende Referenzfrequenz in die Regelschleife eingeführt werden, und sie wird dann direkt auf die VCO-Frequenz übertragen. Enthält die Schleife noch Teiler, so kann auch eine Verkleinerung oder Vergrößerung des Hubes ΔF erfolgen, wie sich unschwer ebenfalls aus (1) und Fig. 1 ableiten läßt.

$$\Delta F_V = n/m \cdot \Delta F_Q \text{ mit } m = m_1 \cdot m_2 \qquad (3)$$

Da meist recht strenge Genauigkeitsforderungen für die erzeugte Frequenz einzuhalten sind, muß der modulierbare Referenzoszillator gewöhnlich als hochpräziser VCXO ausgeführt werden. Ist er imstande, eine kontrollierte und genau definierte analoge oder digitale FM oder PM zu erzeugen, so kann diese dann durch die PLL direkt auf den VCO übertragen werden, ggfs. wie in (3) gezeigt unter Multiplikation mit dem Teilerverhältnis.

Da jede VCO-Frequenzänderung direkt jeder VCXO-Frequenzänderung folgt, gilt dies auch für die Phasen- bzw. Frequenzübergänge, sofern deren Geschwindigkeit unterhalb der durch die Schleifengrenzfrequenz gesetzten Grenze bleibt. Andererseits kann man zu harte Übergänge gezielt durch die Schleifenfilterung verrunden, hierzu sind allerdings innerhalb der Schleife keine beliebigen Filter verwendbar, weil aufgrund der Stabilitätsbedingungen der PLL nur bestimmte Filtertypen zulässig sind.

Man kann solche Regelschleifen auch im Empfänger auf der ZF-Ebene zur Demodulation verwenden, indem man einen VCO mittels einer PLL an die ZF ankoppelt. Die Frequenz- und Phaseninformationen des ZF-Signals werden dann auf die Regelspannung der Demodulations-PLL übertragen und können als Basisbandsignal von dieser abgetrennt werden. Eine geschickte Auslegung der Schleifengrenzfrequenz gestattet es u.a. auch, den Rauschabstand bei der Demodulation zu optimieren.

In einer Ausgestaltung der Erfindung für den Fall der Vierphasenmodulation (QPSK) wird zur Realisierung der erforderlichen Phasensprünge von $\pm\pi/2$ und $\pm\pi$ im Referenzzweig ein Teiler verwendet, dessen Eingangsfrequenz die vierfache der Vergleichsfrequenz ist, die im Phasenvergleicher benötigt wird. Er muß dann auf Teilerverhältnisse von $m_1 = 2, 3, 4, 5$ und $6$ einstellbar sein, die phasenrichtig zu Beginn eines Vergleichsfrequenzzyklus eingestellt werden müssen, was durch eine entsprechende Teilerinitialisierung erreicht werden kann. Das Erscheinen der entsprechenden Vergleichsfrequenzflanke erfolgt bei der normalen Einstellung des Teilerverhältnisses auf 4 nach $2\pi$, entspricht also dem stationären Fall. Ist der Teiler dagegen auf 2, 3, 5 oder 6 eingestellt, so erscheint die betreffende Flanke um $\pi$ bzw. $\pi/2$ vor- oder nacheilend. Da die PLL den VCO auf diese Phasenlage nachzieht, ist damit eine präzise Phasenmodulation mit einem exakt eingehaltenen Phasenhub möglich. Um also einen definierten Phasensprung von z.B. $+ \pi/2$ zu erzeugen, muß der die Modulation durchführende Referenzteiler für einen Zyklus auf das Teilerverhältnis 3 eingestellt werden und nach diesem Zyklus sofort wieder zurück auf 4. Wie in Fig. 3 gezeigt, ergibt sich auf der Vergleichsfrequenz in diesem Fall ein harter Phasensprung um $\pi/2$, der von der PLL auf den VCO übertragen wird. Hierzu setzt ein mehrere Perioden dauernder Phasenregelvorgang ein, an dessen Ende der VCO auf die neue Phasenlage bei gleichgebliebener Frequenz übergegangen ist. Die Form dieses Phasenüberganges wird dabei durch die Schleifendynamik festgelegt, welche im wesentlichen durch die Phasensteilheit des Diskriminators, die Hubsteilheit des VCO, die Eigenschaften des Schleifenfilters und das Teilerverhältnis bestimmt wird. Der Nachteil dieses Verfahrens ist der, daß die Form des Phasenüberganges nicht völlig frei gewählt werden kann, was bestimmte Restriktionen bezüglich der Eigenschaften des modulierten Signals und bezüglich der Modulationsbandbreite mit sich bringt. Es ist damit also weder eine ideale harte Phasentastung noch ein exakt kontrollierbarer weicher Phasenübergang möglich.

Hat der Hauptteiler ein Teilerverhältnis von $n \neq 1$, so ist dies entsprechend den Beziehungen (1) und (2) zu berücksichtigen.

Will man exakt kontrollierte Phasenübergänge erzielen, so muß der gewünschte Phasensprung von $\Delta\phi$ aus einer gewissen Anzahl p von Einzelschritten $\delta\phi i$ zusammengesetzt werden:

$$\Delta\varphi = \sum_{i}^{1, p} \delta\varphi i \qquad (4)$$

Indem man die Teilphasensprünge $\delta\phi i$ in der gewünschten Weise unterschiedlich gestaltet, also von i entsprechend abhängig macht, kann man beliebige treppenförmige Annäherungen an den gewünschten, stetigen Phasenverlauf erzielen. Der Grenzübergang

$$\lim_{p\to\infty} \sum_{i}^{1, p} \Delta\varphi i = \int_{0}^{t} d\varphi(t) \qquad (5)$$

ergibt den gewünschten Übergang theoretisch zwar beliebig genau, ist aber praktisch bzw. technisch nur angenähert realisierbar. Durch passende Wahl der Eigenschaften des Schleifenfilters läßt sich jedoch erreichen, daß die Teilphasensprünge soweit geglättet werden, daß eine gute Annäherung an den gewünschten Verlauf erzielt wird. Eine leicht unterkritische Sprungantwort dürfte dafür der beste Kompromiß sein.

Die Optimierung muß derart erfolgen, daß die Modulationsseitenbänder soweit abgesenkt werden, daß im interessierenden Bereich bis ca. -70 dB$_c$ die Unterschiede zwischen dem theoretischen und dem praktischen Wert vernachlässigbar sind.

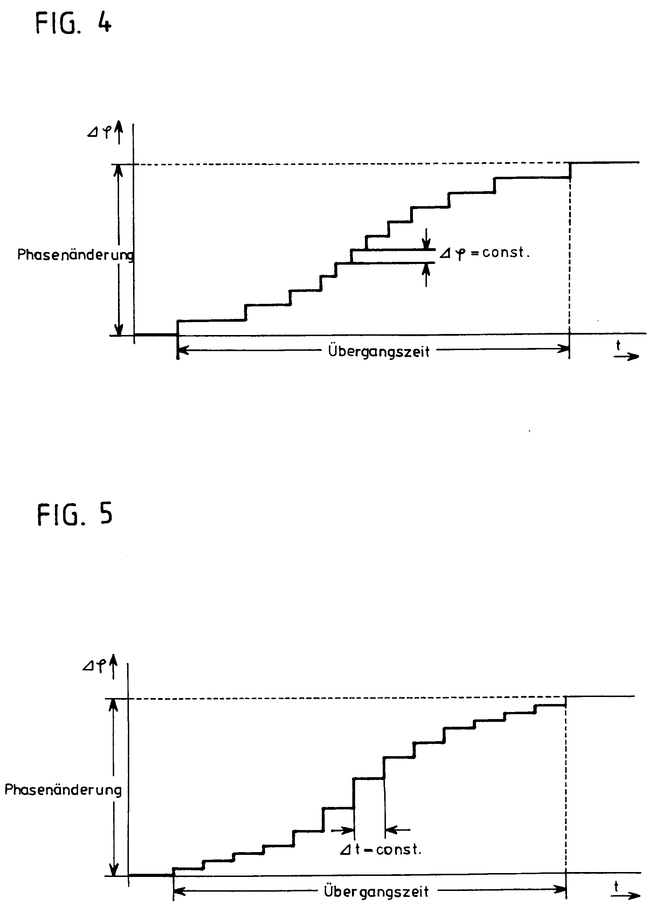

Wenn ein Phasensprung von z.B. $\pi/2$ in p Schritten erfolgen soll und maximale Phasensprünge von $\pm\pi$ möglich sein sollen, dann muß der einstellbare Teiler die Teilerverhältnisse von 2 p bis 6 p überstreichen können; ggfs. muß das Hauptteilerverhältnis n noch entsprechend berücksichtigt werden. Um eine gewünschte gute Annäherung der realisierbaren Treppenkurven an die Sollkurven der Phasenverläufe zu erreichen, müssen bei konstanten Phasensprüngen die Zeitintervalle geeignet variiert werden, Fig.4. Will man dagegen mit einem festen Zeitraster arbeiten, so darf die Schrittweite nicht konstant sein, sondern muß entsprechend variiert werden können, Fig.5. Letztendlich bedeutet dies jedoch, daß die Teilereingangsfrequenz des Modulationsteilers stark anwächst, wodurch man u.U. an die Grenze der Realisierbarkeit infolge der Annäherung an die maximal mögliche Teilereingangsfrequenz stößt, weshalb die Benutzung fester Teilphasensprünge und variabler Zeitintervalle vorzuziehen ist.

Da die erfindungsgemäße Schaltung eine Phasen(bzw. Frequenz-) Modulation mit konstanter Amplitude gestattet, läßt sich das Spektrum der Phasenmodulation leicht beschreiben.

Bekanntlich gilt für Frequenzmodulation mit harmonischen Signalen:

$$s(t) = S_c \cos(\omega_c t + \Delta\phi \sin\omega t) \qquad (6)$$

$$S_C = \sqrt{\frac{2E_B}{T}} \qquad (7)$$

$$s(t) = S_C \sum_{n}^{-\infty,\infty} J_n(\Delta\varphi) \cdot \cos(\omega_C + n\omega)t \qquad (8)$$

Nichtharmonische periodische Modulationssignale kann man als Fourrierreihe darstellen und erhält folglich bei ungeraden Funktionen, auf die sich der Einfachheit halber beschränkt werden soll

$$s(t) = \sin\left\{\omega_C t + \sum_{i}^{1,m} \Delta\varphi_i \sin(i\omega t)\right\} \qquad (9)$$

$$s(t) = S_C \sum_{n_i}^{-\infty,\infty} \left[\prod_{i}^{1,m} J_{ni}(\Delta\varphi_i)\right] \cdot \cos\left\{\omega_C t + \sum_{i}^{1,m} n_i\omega_i t\right\} \qquad (10)$$

Für die hier betrachteten Zusammenhänge kann man annehmen, daß die folgende Näherung verwendbar wird:

$$J_i \cdot J_n \ll 1 \text{ für } i \geq 1 \text{ und } n \geq 1 \qquad (11)$$

Für das durch die Phasensprünge verursachte Schaltspektrum ergibt sich infolgedessen:

$$s(t) \approx \sum_{n}^{-\infty,\infty} \sum_{i}^{1...m} J_{ni} (\Delta \varphi_i) \cdot \cos (\omega_C + n_i \omega t) \qquad (12)$$

Um die oben erwähnte 70-dB$_c$-Bedingung einhalten zu können, muß man die Teilphasensprünge geeignet wählen, wie sich aus (12) ergibt. Sind sie genügend klein, kann man auf eine Verrundung der Phasenstufen theoretisch sogar verzichten. In der Praxis wird man einen günstigen Kompromiß anstreben.

Beim Einsatz der erfindungsgemäßen Schaltung zur digitalen Frequenzmodulation bleibt das Teilerverhältnis so lange geändert, wie die entsprechende Frequenz generiert werden soll. Ausgehend von der Mittenfrequenz sind dann Ablagen nach beiden Seiten möglich. Wird ein schaltbarer Referenzteiler zur Erzeugung der Modulation benutzt, so geht dessen Teilerverhältnis m umgekehrt proportional ein, da $f_v \sim 1/m$ ist. Sofern $m \ll n$ ist, spielt dieser Effekt kaum eine Rolle. Andererseits kann auch der Nutzteiler zur Modulation verwendet werden und dann entfällt dieses Problem, weil $f_v \sim n$ ist. Um statt harter Frequenzumschaltung weiche Frequenzübergänge zu erzielen, muß wie bereits erwähnt eine geeignete Dimensionierung des Schleifenfilters vorgesehen werden und ggfs. die Frequenzumschaltung über mehrere Zwischenschritte geschehen.

In einem Ausführungsbeispiel soll die praktische Realisierung eines GMSK-Modulators oder eines Phasenmodulators erläutert werden.

Dafür bietet es sich an, mit festen Phasensprüngen und variablen Zeitintervallen zu arbeiten. Beispielsweise könnte man eventuell von 10°-Sprüngen ausgehen, d.h. am Eingang des Modulationsteilers müßte die 36-fache Vergleichsfrequenz vorliegen, und das Teilerverhältnis müßte von 35 bis 37 einstellbar sein.

Die Form des Basisbandsignals wird am besten über ein Tabellenverfahren mittels eines ROM in das jeweils benötigte Teilerverhältnis umgesetzt, wobei eine genaue Zeiteinteilung notwendig ist, um das jeweils erforderliche Zeitintervall zu generieren, was mit Hilfe einer zweiten Tabelle in einem zweiten ROM zu erledigen ist; selbstverständlich kann man auch beide ROM zusammenfassen. Die Vergleichsfrequenz muß so gewählt werden, daß das Schleifenfilter einerseits die durch die Phasenquantisierung entstehenden Seitenbänder genügend gut unterdrücken kann, und daß andererseits die Teilerfrequenzen beherrschbar bleiben.

Die erfindungsgemäße Schaltung ist als digitaler Phasen- oder Frequenzmodulator einsetzbar und gestattet, kontrollierte Phasen- oder Frequenzübergänge bei überschaubarem Aufwand zu realisieren. Die Steuerung des Modulationsteilers muß allerdings sehr präzise geschehen und die Dimensionierung als PLL-Schleifenfilter muß sehr sorgfältig erfolgen.

**Patentansprüche**

1. Frequenz- und Phasenmodulator für digitale Modulation bzw. digitale Übertragung, insbesondere für Funkübertragung, **gekennzeichnet dadurch**, daß der Ausgang z.B. eines spannungsgesteuerten Quarzoszillators (VCXO) mit dem Eingang eines Festteilers verbunden ist, daß der Ausgang des Festteilers mit dem Eingang eines einstellbaren Teilers, der gemeinsam mit einem Diskriminator und einem zweiten einstellbaren Teiler initialisierbar ist, verbunden ist, daß der erste einstellbare Teiler mit einem Eingang des Diskriminators verbunden ist, daß der andere Eingang des Diskriminators über den zweiten einstellbaren Teiler mit dem Ausgang eines spannungsgeregelten Oszillators (VCO) verbunden ist, daß der Ausgang des Diskriminators über ein Schleifenfilter mit einem Eingang eines Summierers ( Σ ) verbunden ist, daß der Ausgang des Summierers mit dem VCO verbunden ist und daß am Ausgang des VCO das Ausgangssignal abgreifbar ist.

2. Frequenz- und Phasenmodulator nach Anspruch 1, **gekennzeichnet dadurch**, daß im Fall der Vierphasenmodulation die Eingangsfrequenz des ersten einstellbaren Teilers die vierfache der Vergleichsfrequenz ist, die im Phasenvergleicher benötigt wird und daß der Teiler auf Teilerverhältnisse von $m_1$ = 2,3,4,5,6 einstellbar ist, wenn n = 1 und $m_2$ = 1 sind, bzw. die sinngemäß passenden Werte für $m_1$ entsprechend den aktuellen Werten von n und $m_2$ gewählt wurden.

3. Frequenz- und Phasenmodulator nach Anspruch 1 und 2, **gekennzeichnet dadurch**, daß durch passende Teiler und deren entsprechende Einstellungen beliebige Frequenz- und Phasenhübe mit nahezu beliebigen zeitlichen Übergängen erzeugt werden können.

# FIG. 1

EP 0 551 573 A2

Diskriminator und einstellbare Teiler mit gemeinsamer Initialisierung

$n$

$m_\varphi$

VCO

Festteiler

VCXO

$f_V$

$f_V$

$\boxed{n/1}$

$f_T$

$\boxed{F/P}$

$f_R$

$\boxed{1/m_1}$

$\boxed{1/m_2}$

$f_Q$

$U_{mod}$

Modulationseingang

für $f_{mod} < f_g$

SCHLEIFENFILTER

$\Sigma$

$\boxed{f_g}$

$U_{mod}$

Modulationseingang

für $f_{mod} > f_g$

# FIG. 2

# FIG. 3

## FIG. 4

## FIG. 5